Europäisches Patentamt

European Patent Office

Office européen des brevets

(11) Publication number: **0 166 923**
A2

## (12) EUROPEAN PATENT APPLICATION

(21) Application number: **85105728.1**

(22) Date of filing: **10.05.85**

(51) Int. Cl.⁴: **H 01 L 29/06**
**H 01 L 29/10, H 01 L 29/72**

(30) Priority: **29.06.84 US 626279**

(43) Date of publication of application:
**08.01.86 Bulletin 86/2**

(84) Designated Contracting States:
**DE FR GB**

(71) Applicant: **International Business Machines Corporation**
**Old Orchard Road**
**Armonk, N.Y. 10504(US)**

(72) Inventor: **Chang, Fung-Yuel**
**3 Cedar Court**
**Poughkeepsie New York 12603(US)**

(72) Inventor: **Chu, Shao-Fu, Sanford**
**13 Tanglewood Lane**
**Poughkeepsie New York 12603(US)**

(72) Inventor: **Wang, Wen-Yuan**
**111 Innsbruck Boulevard**
**Hopewell Junction New York 12533(US)**

(74) Representative: **Klein, Daniel Jacques Henri**
**Compagnie IBM France Département de Propriété**
**Industrielle**
**F-06610 La Gaude(FR)**

(54) **High performance bipolar transistor having a lightly doped guard ring disposed between the emitter and the extrinsic base region.**

(57) The present invention relates to a novel semiconductor device, such for example, an NPN bipolar transistor including a standard highly doped $N^+$ emitter (28) separated on its sidewalls fom the $P^+$ extrinsic base region (29) (base contact reach through) by a guard ring shaped region (30) having a significantly lower impurity concentration than the emitter (e.g. $N^-$). Said region (30) is located beneath an insulating spacer (25).

The initial steps of the process are basically standard. The extrinsic base (29) is formed from a boron doped polysilicon contact region (16). The $N^+$ emitter region (28) is self aligned with the $P^+$ polysilicon contact region (16), and remains separated thereof by said $N^-$ region (30). The $N^+$ emitter (28) is formed either using ion implantation techniques or a doped emitter polysilicon contact region. However, according to the teachings of the present invention, the intrinsic base (22) of the transistor is formed in situ, by a low dose low energy P type ion implantation through a mask, made with its concentration peak below the device surface. Subsequently, an intermediate $N^-$ region is formed by implanting N type impurities through the same mask just to convert superficially the conductivity of the top surface above the P intrinsic base into $N^-$ type. The $N^+$ emitter may be then formed in such a way it is separated from the extrinsic base by a guard ring shaped portion (30) of said lightly doped intermediate $N^-$ region. The transistor thus formed will have a controllable narrow base width and optimized concentration, and will exhibit desired low external resistance through the extrinsic base region. Both factors are essential to provide high speed and low power devices.

In addition, this transistor has a significantly high $\beta$ factor (in the range of 150) with a limited modulation of said gain factor; it has also good Emitter-Base breakdown voltages (in the range of 6V).

Lastly, it presents increased inverse $\beta$ which is a highly desirable factor for Merged Transistor Logic (MTL) applications.

./...

FIG. 13

**0166923**

# HIGH PERFORMANCE BIPOLAR TRANSISTOR HAVING A
## LIGHTLY DOPED GUARD RING DISPOSED BETWEEN THE EMITTER
### AND THE EXTRINSIC BASE REGION

The present invention relates to high performance bipolar transistors and more particularly to self aligned, bipolar transistors having a lightly doped guard ring disposed between the emitter and the extrinsic base region, and of same type of conductivity that of the emitter. It also relates to a method for making the same.

In order to improve the performance of bipolar devices, extensive efforts have been made to develop new fabrication processes to produce smaller devices, spaced as closely as possible, which, in turn result in both increased integration density and higher switching speed characteristics. Advanced bipolar devices capitalize on several features, such as the provision of highly doped emitters, self alignment techniques, extrinsic and intrinsic base regions, to improve performances, reliability and manufacturing yields. These features are now briefly commented.

The emitter must be highly doped to reduce resistivity in order to maximize the gain $\beta$.

For the very small bipolar transistor devices, as for example micron size transistors, the base area and therefore the collector base parasitic capacitance is one of the most significant parameter in terms of performance. In conventional bipolar transistors, where the base regions is formed in a single processing step, the active base is the portion of the base region below the emitter. The base contact is formed onto the inactive portion of the base

FI 9 83 048

region surrounding the emitter. In advanced bipolar devices, these two portions are formed according to two different processing steps to accommodate the desire for having different dopant concentrations for both portions. The active base which is lightly doped, is called the intrinsic base, while the inactive base, which is highly doped in order to reduce the base resistance, is referred as to the extrinsic base.

At last, self alignment is a widely employed technique in the industry to reduce size and improve device yield. In its absence, for example, misalignment of the emitter region with respect to the base contact can result in variations in the extrinsic base resistance. In addition, this misalignment can also result in a higher $BV_{BEo}$ (Emitter-Base breakdown voltage) at one side of the emitter than at the other. Self alignment techniques appear to be a "must" in the semiconductor integrated circuits fabrication and is often combined with the use of doped polysilicon, taking advantage of its ability to be both a dopant source (e.g. for forming the extrinsic base) and/or a conductor.

Typical of the prior art, showing Polysilicon Self Alignment (PSA) schemes is that described by Anantha et al in their article entitled "Self Aligned Poly base process", published in July 1980, in Vol. 23 No.2 of the IBM Technical Disclosure Bulletin (ref.1). Anantha et al, describes a NPN bipolar transistor process wherein polysilicon base contacts are used to self align an emitter region. The extrinsic base doping results from the outdiffusion of the P type dopant contained in the polysilicon, while the P type intrinsic base is achieved by ion implantation. In that very conventional structure, the sidewalls of the $N^+$ emitter region are completely adjacent and contiguous to the $P^+$ ring shaped extrinsic base. This structure exhibits low and variable breakdown voltages ($BV_{EBo}$, $BV_{CEo}$), which are some times unacceptable for logic and/or analog applications.

FI 9 83 048

Likewise, US Patent No. 4,252,582 entitled : "Self aligned method for making bipolar transistor having minimum base to emitter contact spacing" granted Feb. 24, 1981, to Anantha et al (ref.2), describes a slightly different variant. In the latter patent, the $N^+$ emitter regions is formed in a pocket shaped base of uniform concentration so that there is a lightly doped P type region between the $N^+$ emitter and the $P^+$ extrinsic base. This construction with the lightly doped P type region is subject to undesirable surface inversion effects.

These two aforementioned references are good examples of advanced polysilicon self aligned bipolar transistors, in which the doping concentration of the emitter is naturally made higher than the one of the base. As this difference becomes larger, the emitter efficiency becomes greater and is more nearly unity. However, highly doped emitters generally cause lattice defects and dislocations, reducing thereby recombination of minority carriers in the base, which in turn results in a significant decrease in gain. It has been suggested then to use an emitter which includes both a small heavily doped portion and a large lightly doped portion. Among the abundant literature detailing that approach, one may cite US Patent 4,000,506 entitled "Bipolar Transistor Circuit" granted Dec. 28, 1976 to Susuma Hirai et al (ref.3). According to the teachings of the Hirai Patent, in the fabrication of a NPN transistor, the emitter is comprised of a small highly doped $N^+$ portion embedded in a large lightly doped $N^-$ region. The $N^-$ emitter portion forms a P-N junction, laterally with the $P^+$ extrinsic base, and at the bottom with the $P^-$ intrinsic base. The first purpose of the $N^+$ portion of the emitter is to facilitate the deposition of an ohmic contact with the emitter. In addition, the $N^+$ portion defines a desired thickness of the $N^-$ region, which is highly resistive, so that said thickness is selected smaller than the diffusion length of minority carriers; it results therefrom a device having higher

FI 9 83 048

cut-off frequencies and higher current amplification factor $(h_{fe})$.

However, those improved performances are to be paid at a very serious cost : the fabrication of such devices is no longer compatible with the desired polysilicon self aligned process where the emitter is formed in a single step. It obviously required two different steps to achieve both highly and lightly doped portions of the emitter. In addition, the $N^-$ doped portion of the emitter, is not self aligned and concentration is not well controlled (because the $N^-$ portion is a part of the epitaxial layer).

It is therefore an object of the present invention to provide a novel high performance bipolar transistor structure, fully compatible with advanced polysilicon self aligned fabrication processes.

It is still a further object of the present invention to provide a novel transistor structure, having greatly improved characteristics, including an increase in the current gain factor $(\beta)$, improved Emitter-Base breakdown voltages $(BV_{EBo})$, improved emitter efficiency and low emitter base capacitance.

It is still a further object of the present invention to provide a novel transistor structure more insensitive to surface inversion effects, therefore reducing variations in the current gain factor.

It is still another object of the present invention to provide a process having for fabricating such a novel transistor structure.

More specifically, the present invention relates to a novel semiconductor device, such for example, a vertical NPN bipolar transistor including a standard highly doped $N^+$

FI 9 83 048

emitter separated on its sidewalls from the $P^+$ extrinsic base region (base contact reach though) by a guard ring shaped intermediate region having a significantly lower impurity concentration than the emitter (e.g. $N^-$) As a first consequence, due to the presence of this intermediate region the lateral emitter injection, is prevented, so that the current only goes through vertical portion of the transistor, say practically only into the intrinsic base. In others words, the active (or intrinsic) base dimensions corresponds essentially to that of the emitter. This small base area results in a low emitter base capacitance which is highly desirable in ultra high performance integrated circuit devices and in addition improves emitter efficiency and current gain factor. The presence of this lightly doped intermediate region between the emitter and the extrinsic base will also make the transistor less sensitive to surface charges (current gain factor modulation will be therefore reduced) and $BV_{EBo}$ will be also significantly increased. The initial steps of the process are basically standard. The extrinsic base is formed from boron doped polysilicon contact regions. The $N^+$ emitter region is self aligned with the P+ polysilicon contact region, and remains separated thereof by said intermediate $N^-$ region. The $N^+$ emitter is formed either using ion implantation techniques or a doped emitter polysilicon contact region.

However according to the teachings of the present invention, the intrinsic base of the transistor is formed in situ, by a low dose low energy P type ion implantation through a mask, made with its concentration peak below the device surface. The transistor thus formed will have a controllable narrow base width and optimized concentration, and at last will exhibit desired low external resistance through the extrinsic base region. Both factors are essential to provide high speed and low power devices. Subsequently, said intermediate region is formed by implanting N type impurities through the same mask just to convert

FI 9 83 048

superficially the conductivity of the top surface above the P base region into $N^-$ type. The $N^+$ emitter may be then formed in such a way it is separated from the extrinsic base by a guard ring shaped portion of said lightly doped intermediate region.

As a result, the present invention provides a NPN transistor having significantly high β factor (in the range of 150) with a limited modulation of said gain factor, as explained above. Good Emitter-Base breakdown voltages (in the range of 6V).

In addition, this transistor presents increased inverse β which is highly desirable for Merged Transistor Logic (MTL) applications.

FIGS. 1 through 12 are schematic partial cross sectional views disclosing a high performance, vertical NPN transistor undergoing fabrication in accordance with the present invention.

FIG. 13 is a schematic partial cross sectional view of the transistor of FIG. 12, after being enlarged to show actual dimensions and provided with standard base, emitter and collector contacts.

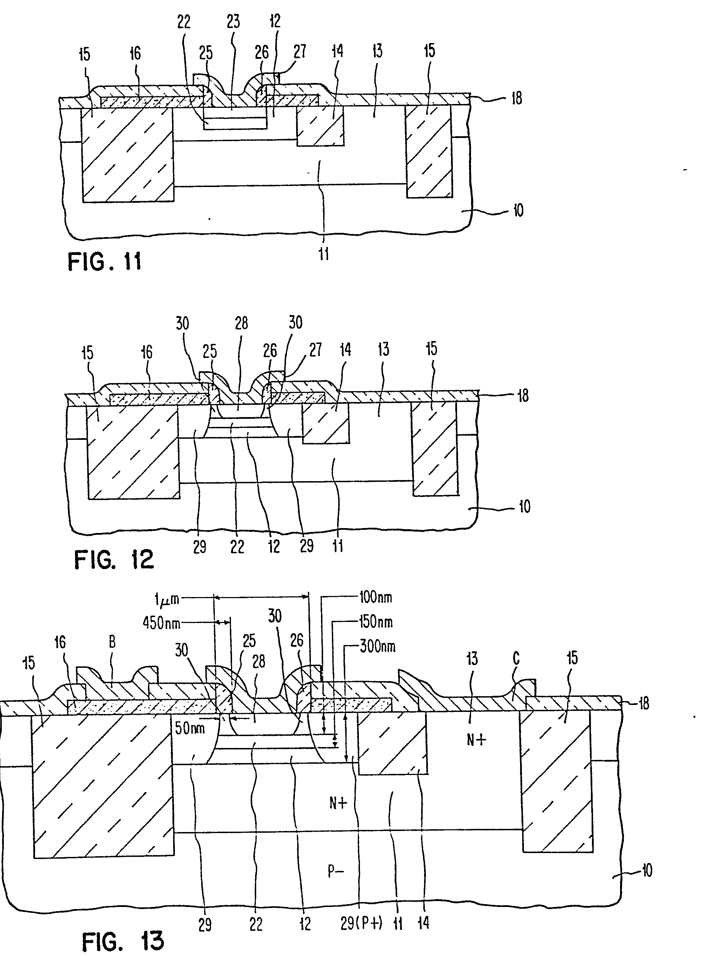

Because the conventional P.S.A. bipolar semiconductor process of fabricating an advanced NPN transistor, is followed through delineation of the polysilicon layer, the initial processing steps will not be detailed thereafter. Those initial steps may be found for example in US Patent 4381953, to Ho et al and assigned to the same assignee as the present invention. This patent is incorporated herein by reference. According to the teachings of the present invention, Ho's process is followed until the $N^+$ collector reach through is formed (this step is illustrated in FIG. 11 of Ho's patent).

FI 9 83 048

For the reader's convenience said initial steps will be briefly summarized thereafter.

A $P^-$ type monocrystalline silicon wafer is the starting substrate. A N type impurity such as arsenic is then introduced into the substrate with a suitable concentration to form the $N^+$ subcollector (resistivity of subcollector is approximately 0.001 ohm/cm². A $N^-$ type epitaxial layer of approximately 1.0 microns to 1.5 microns thickness and 0.3 ohms/cm² of resistivity is grown on the exposed major surface of the wafer.

An oxide layer of about 300 nm is CVD deposited onto the epitaxial layer and delineated according to a standard photolithographic step. Silicon is reactively ion etched from the surface until the subcollector is reached, the shallow trench which results therefrom will isolate the collector reach through from the base. Using new CVD oxide layer and a standard photolithographic step, silicon is once again reactively ion etched to produce the deep trenches for subsequent device isolation. The latter trenches reaches the $P^-$ silicon substrate and have approximately 5-6 microns depth. The remaining CVD oxide is stripped. The wafer is then thermally oxidized in an oxygen ambient to grow about 100-200 nm. A thick oxide layer is then CVD deposited to fill both shallow and deep trenches and also planarize the surface. The structure may be back etched if excellent planarity is necessary.

A resist layer is deposited on the surface and delineated to expose the reach-through region. A N type impurity such as phosphorous is implanted to form a $N^+$ collector reach through. The resist layer is then stripped off.

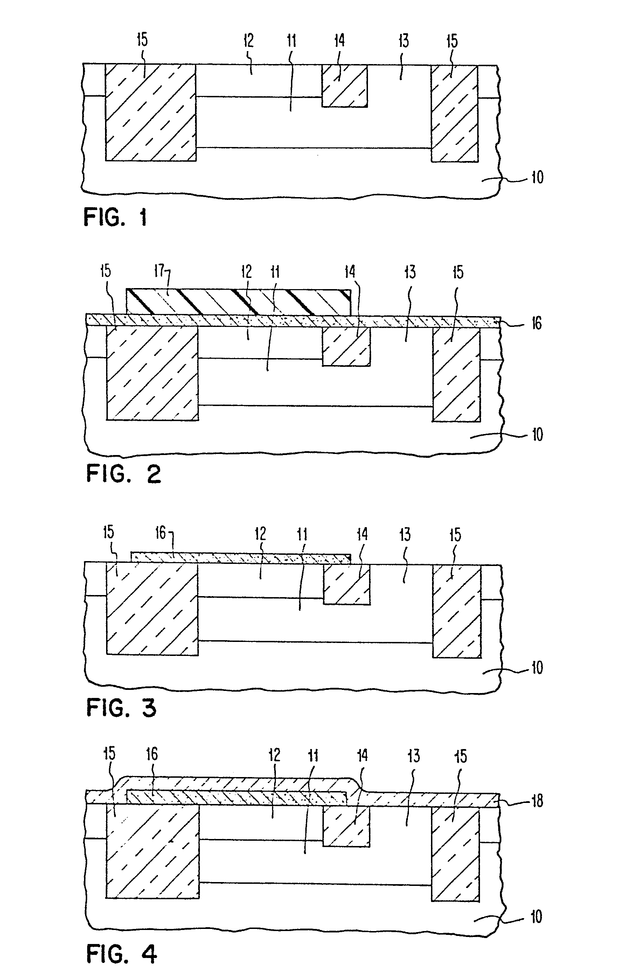

Now turning to FIG.1 of the present application, it is shown the structure resulting from above processing steps: say a $P^-$ silicon substrate 10 provided with a $N^+$ subcollector

FI 9 83 048

region 11, an isolated pocket of the $N^-$ epitaxial layer 12, the $N^+$ subcollector reach through 13, the shallow and deep isolation trenches respectively referenced 14 and 15.

As shown in FIG. 2 a layer of polycrystalline silicon 16 of approximately 300 nm thickness is blanket deposited by chemical vapor deposition onto the entire wafer. Layer 16 constitutes the doped polycristalline base contact. Polysilicon can be either in situ doped with boron during the deposition step, or alternatively it can be doped after the deposition step by boron ion implantation. In either case, its boron concentration should be high, of the order of $10^{20}$ atoms/cm³.

Unlike, Ho's disclosure, said polysilicon layer is patterned at once with a standard photolithographic step. A photoresist layer 17 is deposited on the whole wafer exposed, and developed to form an etching mask where the unwanted polysilicon will be subsequently removed by reactive ion etching in a gas mixture of $CCl_2F_2$ and $O_2$.

The resist layer 17 is then stripped off.

The structure at this point is shown in FIG. 3 illustrating that it remains an island 16 of polysilicon covering the epitaxial layer 12 where the extrinsic and intrinsic base regions are to be formed.

As seen in FIG. 4 a layer 18 of silicon dioxide of approximately 300 nm is blanket deposited by chemical vapor deposition onto the structure. Since such oxide layer is highly conformal, the oxide on the sides as well as on the top of the polysilicon layer 16, will be approximately 300 nm.

Next, a photoresist layer 19 is deposited on the wafer. The resist layer is exposed and developed to form a window 20

FI 9 83 048

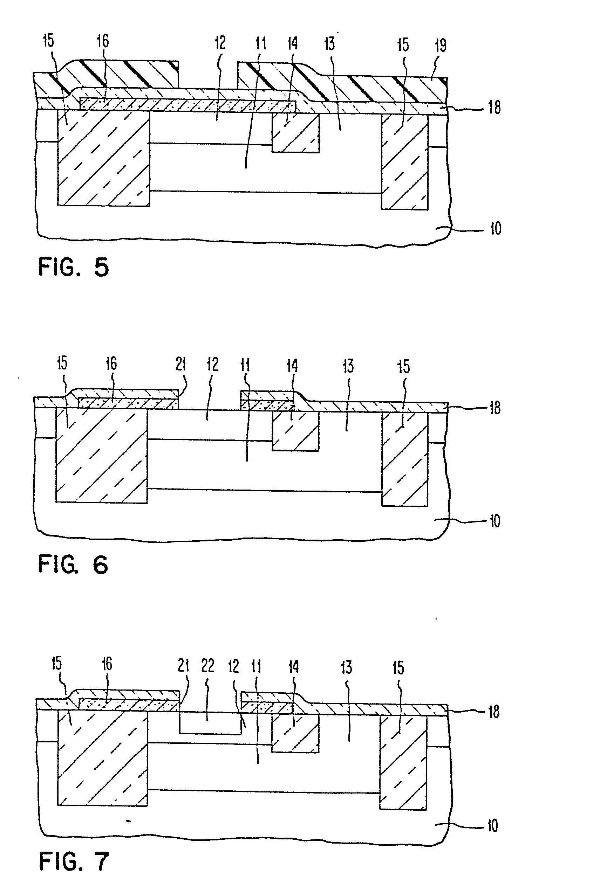

where the oxide and the polysilicon will be removed. Window 20 corresponds broadly to the intrinsic base region. The resulting structure is shown in FIG. 5. Then, using the patterned thick photoresist layer 19 as a mask, the exposed areas of the oxide layer 18 and the polysilicon layer 16 are removed in sequence by a reactive ion etch in a $CF_4$ based gas mixture. The resist layer 19 is stripped off. The remaining portion of the doped polysilicon layer 16 over the epitaxial layer 12 corresponds to the extrinsic base region to be subsequently formed. Opening 21 delineates the intrinsic base regions. At this stage, the structure is shown in FIG. 6.

Next a low energy (<20 KeV) boron ion implantation, at a dose of 1 x $10^{14}$ atoms/cm³, is performed in the opening 21, followed by a 900°C heat cycle to form the intrinsic base region 22. The resulting structure is shown in FIG. 7.

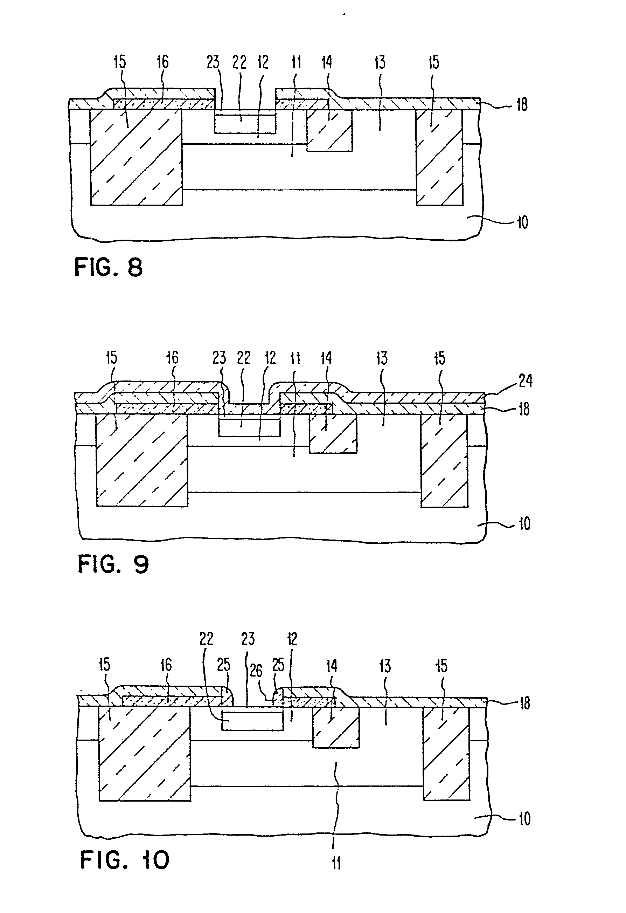

Then a low energy (<10KeV) at a higher dose of 1 x $10^{15}$ atoms/cm³ implantation of arsenic ions is done, to form a lightly doped intermediate region 23 shown in FIG.8. This implantation must compensate for changing the top part of the base region 22 from P type to N type of conductivity.

As seen in FIG. 9, a layer of silicon dioxide 24 (or any other insulating material) of approximately 450 nm thickness is deposited by chemical vapor deposition. As said previously, such an oxide layer is highly conformal. Next, the oxide layer 24 is then etched away in a directional Reactive Ion Etching in $CF_4$ and $H_2$ gas mixture equipment. During this step, arsenic atoms are driven deeper into the base region 22 (not represented). Since, the reactive ion etch is highly directional (it etches faster the portions which are substantially horizontal than the portions substantially vertical), the 450 nm thick oxide 24 on the sides of superimposed layers 16 and 18 in the opening 21, will remain. The remaining portions of layer 24 form an

**0166923**

insulating spacer 25 which in turn defines the emitter opening 26 as apparent from FIG. 10.

As shown in FIG. 11, a layer of heavily arsenic doped polysilicon is blanket deposited onto the whole structure and delineated with a standard photolithographic step (not represented) to leave the polysilicon emitter contact 27. Because the N type arsenic atoms of region 23 have been driven in the P type intrinsic base region 22, the P-N junction has slightly moved downwards.

Lastly, a thermal cycle is done to outdiffuse the $N^+$ dopants from the arsenic doped emitter contact 27, into the lightly doped intermediate region 23 and form a $N^+$ emitter 28. Parameters of this cycle are tightly controlled so that the emitter region 28 just reaches the P-N junction between said lightly doped intermediate region 23 and the intrinsic base region 22. Simultaneously, the boron atoms will out-diffuse from the heavily doped polysilicon layer 16 to form the extrinsic base region 29. As it may be seen from FIG. 12, the $N^+$ emitter region 28 is spaced apart the extrinsic base region 29, by a remaining portion 30 of said intermediate region 23. Said remaining portion 30 which is, either ring or square annular shaped has demonstrated to have various and significant advantages; these will be further explained with reference to FIG. 13.

However, it is to be noted that alternatively to the processing steps illustrated in FIGS. 11 and 12, the emitter region 23 may be also achieved by a low energy arsenic ion implant. Arsenic dopants are prevented to be introduced in polysilicon layer 16 by the shielding action of oxide layer 18.

A similar thermal cycle will anneal this implant and drive the arsenic dopants into intermediate region 23 to form the emitter 28, while the extrinsic region 29 will be produced

FI 9 83 048

by the out diffusion of boron dopants from layer 16 as explained above. In fact, the man skilled in the art knows that formation of said extrinsic base 29, is not completed only at this stage of the process, but proceeds from a gradual drive in of boron into the epitaxial layer at each hot temperature processing step.

The device is now ready for deposition and fabrication of the metallurgy which will interconnect the different parts of the device with others devices on the wafer. The forming of this metallurgy is well known in the art and will not be described here.

FIG. 13 shows an enlarged view of the NPN transistor of FIG. 12 say, such as obtained in accordance with the process of the present invention. The structure is provided with Emitter, Base and Collector contacts, the most important dimensions are indicated in that figure. The depth of the emitter, e.g. 100 nm, is about the same as the depth of the intermediate region after having been driven in as seen in FIG. 13. The emitter is then completely surrounded and spaced apart from the $P^+$ extrinsic base 29 by a remaining portion 30 of said intermediate base thickness. The active base is therefore only the intrinsic base (in the range of 150 nm). Because the width of the N guard ring 30 is very small (e.g. 50 nm), it is obvious to the man skilled in the art that the various parameters of the process, and more particularly the step of forming the oxide spacer 25 which in turn defines the emitter 28, must be tightly controlled. Badly controlled process may result in link up of the emitter and the extrinsic base, therefore providing a standard like NPN transistor not benefiting of the advantages offered by the present invention which have been mentioned in detail above say: substantial increase in the current gain factor, improved emitter-base breakdown voltage, and improved emitter efficiency. In addition, the improved transistor is less sensitive to surface inversion

FI 9 83 048

**0166923**

effect and has therefore a noticeable reduction of current gain factor modulation.

Lastly, this transistor exhibits increased inverse β which is highly desirable for Merged Transistor Logic (MTL) applications.

FI 9 83 048

CLAIMS

1. A high performance, vertical NPN transistor structure formed within an integrated circuit having:

   an isolated pocket of N type epitaxial layer (12) within a $P^-$ type monocrystalline silicon substrate (10);

   a $N^+$ subcollector region (11);

   a $N^+$ collector reach through (13) which connects said subcollector to a major surface of the structure;

   a $N^+$ emitter region (28) extending from said major surface;

   a base region including a P intrinsic base region (22) located above said subcollector and below said emitter; a $P^+$ extrinsic base (29) surrounding both said emitter and intrinsic base regions;

   characterized in that there is a portion (30) of a lightly doped $N^-$ intermediate region (23, FIG. 11) extending from said major surface and located between said emitter and extrinsic base.

2. A transistor as recited in claim 1 wherein there is a remaining portion of said epitaxial layer (12, FIG. 13) between said intrinsic base region (22) and said subcollector region (11).

3. A high performance vertical NPN transistor having a heavily doped $P^+$ base contact (16) separated from the emitter opening (26) by an insulating spacer (25) comprising:

a heavily doped $N^+$ emitter region (28);

a heavily doped $P^+$ extrinsic base region (29) formed by out diffusion of P type dopants from said doped polysilicon base contact (16);

an intrinsic P base region (22) beneath said heavily doped emitter region and extending into contact with said extrinsic base region;

a N type collector region (12, 11) beneath said intrinsic base region;

and, a portion (30) of a lightly doped $N^-$ intermediate region (23, FIG. 11) located beneath said insulating spacer and extending between said heavily doped emitter (28) and said heavily doped extrinsic base (29).

4.   A transistor as recited in claim any of above wherein the depth of said intermediate region (23, FIG. 11) is equal to the depth of said emitter (28).

5.   A transistor as recited in claim 4 wherein said portion (30) of said intermediate region (23, FIG. 11) is either ring or square annular shaped.

6.   In a process for fabricating an improved bipolar transistor within an integrated circuit having an isolated region of N type epitaxial layer (12) within a $P^-$ type monocrystalline silicon substrate (10), a $N^+$ subcollector region (11), a $N^+$ collector reach through (13) which connects said subcollector to a major surface of the structure, said process further comprising the steps of:

a)   forming a heavily boron doped polysilicon base contact layer (16) over said isolated region;

FI 9 83 048

b) blanket depositing a first insulating layer (18) onto the whole structure;

c) forming an opening (21) in both layers (16, 18) to define the intrinsic base of the transistor;

d) ion implanting boron ions into said opening (21) to form said intrinsic base (22);

e) ion implanting arsenic ions into said opening (21) to form a lightly doped $N^-$ intermediate region (23) close to the exposed major surface;

f) blanket depositing a second insulating layer (24) by chemical Vapor Deposition onto the whole structure;

g) reactive ion etching the horizontal portions of said second insulating layer (24), to leave an insulating spacer (25) on the sidewalls of said opening (21) to define the emitter opening (26);

h) forming the $N^+$ doped emitter (28);

i) utilizing a heat cycle to drive in the dopants from said intermediate region (23) and from said emitter (28) until the latter reaches the intrinsic base region (22), and to out diffuse and drive in the P dopant from the $P^+$ polysilicon base contact to form the $P^+$ extrinsic base (29), but leaving a portion (30) of said intermediate region extending between said emitter and extrinsic base regions and located beneath said insulating spacer (25).

7. In a process as recited in claim 6 wherein said step h) of forming the $N^+$ emitter (28) is obtained from out

FI 9 83 048

**0166923**

diffusing the N dopant from a $N^+$ doped polysilicon emitter contact (27).

8. In a process as recited in claim 6 wherein said step h) of forming the $N^+$ emitter (28) is obtained by implanting arsenic ions at the vicinity of the exposed surface in emitter opening (26).

FI 9 83 048

FIG. 1

FIG. 2

FIG. 3

FIG. 4

) 83 048

FIG. 5

FIG. 6

FIG. 7

33 048

0166923

15  16    23 22 12   11 14    13    15

FIG. 8

15     16    23 22 12 11 14     13     15

FIG. 9

22    23    12
15   16    25   26 25    14    13    15

FIG. 10

11

9 83 048

FIG. 11

FIG. 12

FIG. 13